# DEMANDE DE BREVET EUROPEEN

(11) **EP 4 174 912 A1**
(43) Date de publication de la demande: **03.05.2023**
(21) Numéro de dépôt: 22204367.1
(22) Date de dépôt: 28.10.2022
(51) Int. Cl.: H01L 21/20, H01L 33/00

(54) **PROCÉDÉ DE CROISSANCE VERTICALE D'UN MATÉRIAU III-V**

(30) Priorité: 02.11.2021 FR 2111632
(71) Demandeur: Commissariat à l'énergie atomique et aux énergies alternatives, 75015 Paris (FR); Centre national de la recherche scientifique, 75016 Paris (FR)
(72) Inventeur: CHARLES, Matthew, 38054 GRENOBLE Cedex 09 (FR); CORDIER, Yvon, 06560 VALBONNE (FR)
(74) Mandataire: Hautier IP

(57) **Abrégé**

L'invention concerne un procédé de croissance d'un matériau III-V comprenant une fourniture d'un empilement comprenant une couche cristalline en matériau III-V, une première couche de masquage surmontant la couche de germination, la première couche de masquage présentant au moins une première ouverture, une formation d'au moins une couche, un dépôt d'une deuxième couche de masquage recouvrant une face supérieure de la couche sacrificielle, une formation d'au moins une deuxième ouverture dans la deuxième couche de masquage, un retrait de la couche sacrificielle sélectivement à la première couche de masquage et à la deuxième couche de masquage, une croissance par épitaxie d'un matériau à base du matériau III-V à partir de la couche de germination, une formation d'au moins une troisième ouverture dans la deuxième couche de masquage et une croissance par épitaxie d'au moins un matériau à base du matériau III-V à partir de la première couche épitaxiée.

## Description

### DOMAINE TECHNIQUE

La présente invention concerne la croissance de matériaux III-V, tels que le GaN. Elle permet avantageusement la croissance de matériaux III-V pour réaliser des dispositifs micro-électroniques dits verticaux. Elle trouve par exemple pour application particulièrement avantageuse le domaine de l'électronique de puissance.

### ETAT DE LA TECHNIQUE

Les composants électroniques de puissance, typiquement à base de GaN, sont actuellement confectionnés à partir de dispositifs dits latéraux, comme les transistors à électron à haute mobilité, connus sous le terme anglais de « High Electron Mobility Transistor » (HEMT), ou à partir de dispositifs dits verticaux réalisés principalement sur des substrats de GaN.

Les dispositifs verticaux présentent de nombreux avantages. Du fait de leurs dimensions, ils occupent moins de superficie que les dispositifs latéraux, et rencontrent également moins de problèmes liés à la présence de pièges.

Cependant, les solutions actuelles pour obtenir ces dispositifs verticaux présentent de nombreux inconvénients.

Une solution consiste à faire croître verticalement une couche de GaN à partir de substrats de GaN, également désignés substrats autoporteur ou free-standing GaN substrats. Cette solution permet d'obtenir de bonnes performances. En revanche, cette solution présente comme inconvénient que ces substrats de GaN sont très coûteux et sont uniquement disponibles dans de petites dimensions, typiquement des substrats de 5 cm (5.10⁻²m) de diamètre.

Une alternative à la croissance sur substrat de GaN est la croissance sur substrat silicium (« GaN sur silicium »), qui a l'avantage d'être plus économique et de permettre d'accéder à des substrats de grands diamètres. Cette alternative présente en revanche deux inconvénients majeurs. Les couches de GaN ainsi obtenues présentent des densités de dislocation très élevées, de l'ordre de 10⁹ cm⁻². Par ailleurs, du fait de la différence entre le paramètre de maille du GaN et celui du silicium, il est difficile d'obtenir des couches très épaisses, pourtant nécessaires à la fabrication de dispositifs verticaux.

La présente invention vise donc à réduire les inconvénients mentionnés ci-dessus liés à la croissance de couches épaisses de matériaux III-V, et par exemple la croissance de couches épaisses de matériaux III-N et plus particulièrement de GaN sur un substrat de silicium.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre les objectifs mentionnés ci-dessus, un premier aspect de l'invention concerne un procédé de croissance d'un matériau III-V comprenant :
- Une fourniture d'un empilement comprenant une couche cristalline en matériau III-V dite couche de germination, une première couche de masquage surmontant la couche de germination, la première couche de masquage présentant au moins une première ouverture exposant une partie d'une face supérieure de la couche de germination,
- Une formation d'au moins une couche sacrificielle remplissant la première ouverture et s'étendant depuis la première ouverture sur au moins une première région d'une face supérieure de la première couche de masquage,
- Un dépôt d'une deuxième couche de masquage recouvrant une face supérieure de la couche sacrificielle et recouvrant au moins une deuxième région de la face supérieure de la première couche de masquage, la deuxième région étant non recouverte par la couche sacrificielle,
- Une formation d'au moins une deuxième ouverture dans la deuxième couche de masquage de sorte à rendre accessible une partie de la face supérieure de la couche sacrificielle,
- Un retrait de la couche sacrificielle sélectivement par rapport à la première couche de masquage et à la deuxième couche de masquage, de sorte à former au moins une cavité,
- Une croissance par épitaxie d'un matériau à base du matériau III-V à partir de la couche de germination dans la première ouverture et dans la cavité, de sorte à former au moins une première couche épitaxiée s'étendant dans la première ouverture et dans la cavité et présentant une face supérieure s'étendant principalement dans un plan XY,
- Une formation d'au moins une troisième ouverture dans la deuxième couche de masquage sur une portion permettant d'exposer une partie de la face supérieure l'au moins une première couche épitaxiée,
- Une croissance par épitaxie d'au moins un matériau à base du matériau III-V à partir de la première couche épitaxiée, la direction privilégiée de la croissance étant normale au plan XY, de sorte à former au moins une deuxième couche épitaxiée s'étendant depuis l'au moins une première couche épitaxiée.

Le confinement lors de la croissance de la première couche épitaxiée, ainsi que la forme en coude de cette dernière, permet d'éviter la propagation des dislocations et d'obtenir une première couche épitaxiée présentant une densité de défauts très faible, propice à la croissance verticale, à partir de cette même première couche épitaxiée, d'une deuxième couche épitaxiée épaisse et présentant elle-même peu de défauts. Ainsi, le procédé permet de réaliser une croissance verticale d'un matériau III-V en évitant les problèmes liés à la propagation des dislocations.

Selon un autre aspect, l'invention porte sur un dispositif microélectronique, comprenant un empilement de couches selon une direction verticale, ledit empilement comprenant, à partir d'une surface inférieure dudit empilement, une couche de germination cristalline en un matériau III-V, une première couche cristalline à base de ce même matériau et une deuxième couche cristalline à base de ce même matériau, caractérisé en ce que la première couche cristalline présente une zone qui forme saillie, en projection dans le plan XY, par rapport à la deuxième couche.

De préférence, la première couche s'étend selon une direction Z normale au plan XY sur une épaisseur H₁₁₀ et la deuxième couche s'étend selon cette direction Z sur une épaisseur H₁₂₀, avec H₁₂₀>2*H₁₁₀ et de préférence H₁₂₀>3*H₁₁₀. De préférence la couche de germination et la première couche épitaxiée d'une part, et la première couche épitaxiée et la deuxième couche épitaxiée d'autre part, sont en contact.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1 à 12 représentent les étapes principales d'un exemple de procédé de réalisation.
La figure 1 représente un empilement comprenant une couche cristalline d'un matériau III-V, dite couche de germination et une première couche de masquage surmontant la couche de germination.
Les figures 2 à 12 présentent des étapes appliquées à l'empilement illustré en figure 1. La figure 12 illustre un exemple de structure que l'on peut obtenir, et qui comporte une couche épaisse épitaxiée de matériau III-V.
Les figures 13 et 14 illustrent un mode de réalisation alternatif, permettant de réduire les risques de dopage parasite de la couche épitaxiée de matériau III-V.
Les figures 15 et 16 illustrent des situations défavorables pour la conduction électrique verticale et le confinement des défauts pouvant se produire lors de la croissance de la première et de la deuxième couche épitaxiée respectivement, lorsque le procédé n'est pas mis en œuvre.
Les figures 17 et 21 illustrent différents exemples de formes de couches sacrificielles pouvant être adoptées dans le cadre de la mise en œuvre du procédé, ces formes permettant d'obtenir des formes variées de couche épitaxiée de matériau III-V.
Les figures 22 à 27 illustrent plusieurs modes de réalisation pour confectionner des composants micro-électroniques de puissance tels que des diodes p-n, ou des LEDs.

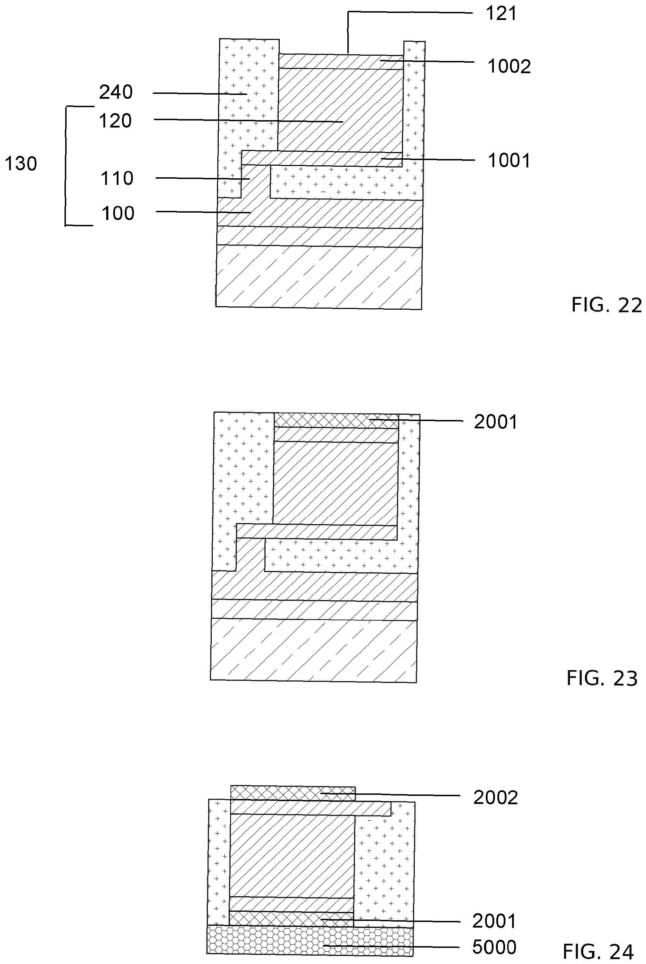

Les figures 22 à 24 illustrent des étapes de réalisation d'une diode p-n.

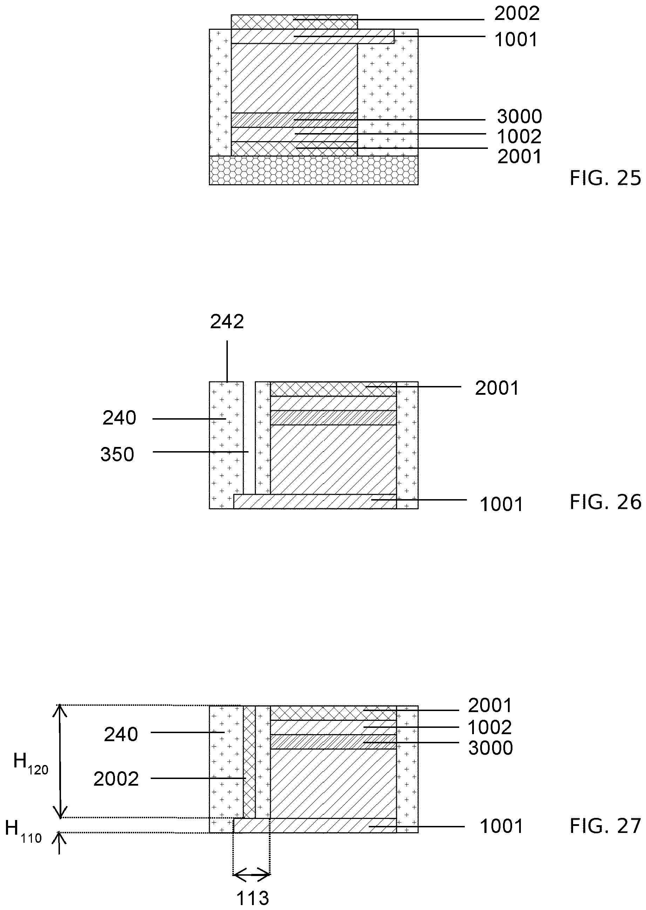

Les figures 25 à 27 illustrent des étapes spécifiques à la réalisation d'une LED.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions et épaisseurs des différentes couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple particulier, selon une coupe parallèle au plan XY, la première ouverture présente une dimension L₃₁₀ et la face supérieure de la première couche épitaxiée présente une dimension L₁₁₁, avec L₁₁₁>5*L₃₁₀, de préférence L₁₁₁>10*L₃₁₀ et de préférence L₁₁₁>20*L₃₁₀. Avantageusement, selon une coupe parallèle au plan XY, la première ouverture s'étend sur une surface S₃₁₀ et la face supérieure de la première couche épitaxiée sur une surface S₁₁₁, avec S₁₁₁>5*S₃₁₀, de préférence S₁₁₁>10*S₃₁₀ et de préférence S₁₁₁>20*S₃₁₀. Ainsi, la dimension de la première ouverture est très inférieure à la dimension de la première couche épitaxiée. Cela permet d'éviter la propagation des dislocations depuis la face supérieure de la couche de germination jusque dans la première couche épitaxiée.

Préférentiellement, la première couche épitaxiée présente une épaisseur H₁₁₀ et la deuxième couche épitaxiée présente une épaisseur H₁₂₀, avec de préférence H₁₂₀>2*H₁₁₀, de préférence H₁₂₀>3*H₁₁₀ et de préférence H₁₂₀>5*H₁₁₀, les épaisseurs H₁₂₀ et H₁₁₀ étant prises selon une direction Z perpendiculaire au plan XY. Ainsi, l'épaisseur de la deuxième couche épitaxiée est très supérieure à l'épaisseur de la première couche épitaxiée. Cela permet d'éviter la propagation des dislocations dans la première couche épitaxiée, puis d'obtenir une épaisseur important de matériau III-V grâce à la deuxième couche épitaxiée.

Selon un exemple, le plan XY est parallèle à la face supérieure de la couche de germination et à une face supérieure du substrat.

Selon un exemple particulier, le procédé comprend, après la formation de la première couche épitaxiée et avant le retrait de la deuxième couche de masquage, un dépôt d'une troisième couche de masquage sur la deuxième couche de masquage, et une formation dans la troisième couche de masquage d'au moins une quatrième ouverture présentant des flancs et configurée pour exposer une partie de la deuxième couche de masquage, les flancs de la troisième couche de masquage étant conservés lors de la croissance de la deuxième couche épitaxiée à partir de la première couche épitaxiée. Cela permet de confiner la croissance du matériau III-V lors de la réalisation de la deuxième couche épitaxiée.

Avantageusement, les flancs de la troisième couche de masquage présentent une hauteur H₂₃₁ et la deuxième couche épitaxiée présente une épaisseur H₁₂₀, telle que H₂₃₁≥H₁₂₀, les épaisseurs H₂₃₁ et H₁₂₀ étant prises selon une direction Z perpendiculaire au plan XY.

Selon un mode de réalisation, une couche de protection est déposée au moins sur les flancs de la troisième couche de masquage, et de préférence sur des flancs définissant la troisième ouverture de la deuxième couche de masquage, avant l'étape de croissance de la deuxième couche épitaxiée, cette couche de protection recouvrant les flancs de la troisième couche de masquage, et de préférence les flancs de la deuxième couche de masquage, durant l'étape de croissance de la deuxième couche épitaxiée. Cela permet d'éviter la diffusion involontaire d'éléments de la troisième couche de masquage jusque dans la deuxième couche épitaxiée. On évite ainsi un dopage involontaire de la deuxième couche épitaxiée.

Selon un mode de réalisation, après sa gravure, la couche sacrificielle forme des îlots disjoints, chaque îlot s'étendant depuis une unique ouverture formée dans la première couche de masquage.

Selon un exemple particulier, la cavité présente une portion de section triangulaire selon une coupe parallèle au plan XY, ladite portion s'étendant depuis l'aplomb de la première ouverture.

Selon un autre mode de réalisation, la croissance de la première couche épitaxiée se fait dans toutes les directions du plan XY. Selon un mode de réalisation, la première ouverture est située à l'aplomb d'un centre de la cavité. Selon un exemple particulier, la cavité est de forme hexagonale.

Selon un mode de réalisation, le procédé comprenant également les étapes suivantes :
- un dopage parmi un dopage de type N ou de type P de la première couche épitaxiée,
- un dopage de l'autre type parmi un dopage de type N ou de type P d'une deuxième zone dopée de la deuxième couche épitaxiée, la deuxième zone dopée s'étendant depuis face supérieure de la deuxième couche épitaxiée.

Selon un exemple, au moins un dopage parmi le dopage de type P et le dopage de type N est réalisé à partir d'accepteurs et/ou de donneurs profonds respectivement. Cela permet d'augmenter la résistivité électrique de la deuxième couche épitaxiée. Ce mode de réalisation trouve notamment ses applications dans le domaine des interrupteurs haute tension déclenchés optiquement. Un accepteur profond et donneur profond sont des composés présentant des pièges dont la différence de niveau d'énergie avec la bande de valence ou de conduction respectivement au moins deux fois supérieure à l'énergie caractéristique kT, k étant la constante de Boltzmann et T la température absolue.

Selon un exemple particulier, le dopage de la première couche épitaxiée est effectué pendant le dépôt de cette même couche.

Selon un exemple, le dopage de la deuxième couche épitaxiée est effectué lors de la croissance de cette même couche.

Selon un mode de réalisation, le procédé comprend en outre :
- une réalisation d'une première électrode en contact électrique avec la deuxième couche épitaxiée,
- une réalisation d'une deuxième électrode en contact électrique avec la première couche épitaxiée.

Selon un exemple, l'empilement forme une jonction PN.

Selon un mode de réalisation, le procédé comprend en outre une formation de puits quantiques au sein de la deuxième couche épitaxiée, de sorte à fabriquer une LED.

Selon un exemple particulier, la première électrode est déposée dans une cinquième ouverture préalablement réalisée dans la troisième couche de masquage et dans la deuxième couche de masquage de sorte à exposer une partie de la face supérieure de la première couche épitaxiée et la rendre accessible depuis une face supérieure la troisième couche de masquage.

Selon un exemple, la cinquième ouverture est située à l'aplomb de la première ouverture.

Selon un mode de réalisation, le matériau III-V de la première couche épitaxiée et le matériau III-V de la deuxième couche épitaxiée sont des matériaux III-N, et de préférence sont des matériaux à base de nitrure de gallium et de préférence sont faits de nitrure de gallium.

Selon un exemple le matériau III-V de la première couche épitaxiée et le matériau III-V de la deuxième couche épitaxiée sont identiques.

Selon un exemple la deuxième couche épitaxiée présente plusieurs matériaux III-V. Une portion de la deuxième couche épitaxiée au contact de la première couche épitaxiée présente un matériau III-V identique à celui de la première couche épitaxiée. Une autre portion de la deuxième couche épitaxiée qui n'est pas au contact de la première couche épitaxiée présente un matériau III-V différent de celui de la première couche épitaxiée. Ce matériau III-V différent peut par exemple former un puits quantique. De préférence, les matériaux de la première couche épitaxiée et de la deuxième couche épitaxiée sont à base du même matériau que celui de la couche de germination. De préférence le matériau de la première couche épitaxiée est identique au matériau de la couche de germination.

Selon un mode de réalisation, les étapes du procédé présentent les caractéristiques suivantes :
- la première couche de masquage présente une pluralité de premières ouvertures exposant chacune une partie de la face supérieure de la couche de germination,
- l'étape de formation d'au moins une couche sacrificielle est effectuée de sorte à former une pluralité de couches sacrificielles, disjointes les unes des autres, remplissant chacune au moins une première ouverture,
- la deuxième couche de masquage recouvre la pluralité de couches sacrificielles,
- l'étape de formation d'au moins une deuxième ouverture est effectuée de sorte à rendre accessible une partie de la face supérieure de chacune des couches sacrificielles,
- l'étape de formation d'au moins une deuxième ouverture est effectuée de sorte à former une pluralité de deuxièmes ouvertures, de sorte à rendre accessible une partie de la face supérieure de chaque couche sacrificielle,
- l'étape de retrait de chaque couche sacrificielle sélectivement par rapport à la première couche de masquage et à la deuxième couche de masquage, est effectuée de sorte à former au moins une pluralité de cavités,
- L'étape de croissance par épitaxie du matériau III-V à partir de la couche de germination est effectuée de sorte à former une pluralité de premières couches épitaxiées, chaque première couche épitaxiée étant située dans une cavité,
- La formation d'au moins une troisième ouverture est effectuée de sorte à exposer une partie de la face supérieure de chaque première couche épitaxiée,
- L'étape de croissance par épitaxie du matériau III-V à partir de au moins une première couche épitaxiée est effectuée de sorte à former une deuxième couche épitaxiée s'étendant depuis chaque première couche épitaxiée.

Ainsi, on obtient, sur un même substrat, une pluralité de couches épaisses de matériau III-V par épitaxie verticale.

Avantageusement, les premières couches épitaxiées sont disjointes. Avantageusement, l'étape de croissance par épitaxie du matériau III-V à partir de chaque première couche épitaxiée est effectuée de sorte que les deuxièmes couches épitaxiées sont disjointes.

Selon un exemple, chaque deuxième couche épitaxiée est destinée à former un dispositif microélectronique, de préférence un dispositif vertical.

Selon un exemple, la croissance par épitaxie du matériau III-V à partir de la couche de germination est effectuée de sorte que la première couche est épitaxiée dans toute la cavité. Ainsi elle remplit entièrement la cavité.

Le dispositif peut présenter au moins l'une quelconque des caractéristiques optionnelles qui peuvent éventuellement être utilisées en association ou alternativement :
Selon un exemple particulier, la première couche épitaxiée présente une première zone dopée, de dopage de type N ou de type P, et la deuxième couche épitaxiée présente à sa surface une deuxième zone dopée, de dopage de l'autre type parmi le type N ou le type P.

Selon un exemple, l'empilement forme en partie au moins une diode Schottky ou une d'une diode n-i-n, p-i-n ou p-i-p ou encore d'un transistor MOSFET.

Selon un mode de réalisation particulier, le dispositif comporte une première électrode en contact avec la deuxième zone dopée, et une deuxième électrode en contact avec la première zone dopée.

Selon un exemple particulier, la deuxième couche épitaxiée est entourée d'une quatrième couche de masquage et la deuxième électrode s'étend au travers de la quatrième couche de masquage et depuis une face supérieure de la quatrième couche de masquage jusqu'à la première zone dopée.

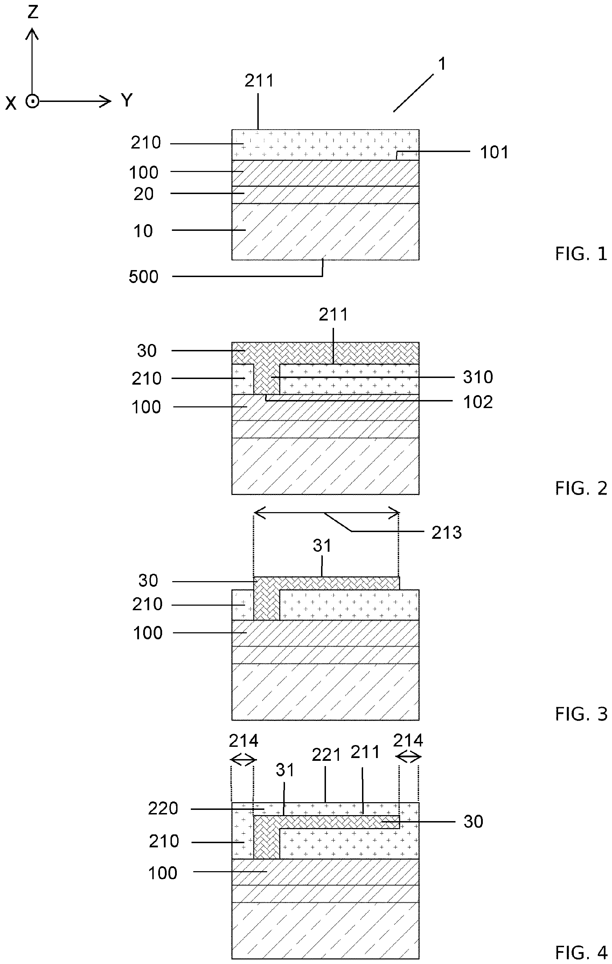

Dans la présente invention, le procédé est en particulier dédié à la fabrication de dispositifs microélectroniques verticaux. Cela signifie que la croissance du matériau III-N s'effectue de manière privilégiée selon une direction perpendiculaire au plan de la face inférieure du substrat, cette direction correspondant à l'axe Z du repère orthogonal XYZ illustré en figure 1.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Dans la description qui suit, sauf indication contraire, lorsque l'on fait référence à des qualificatifs de position absolue, tels que les termes « avant », « arrière », « haut », « bas », etc., ou relative, tels que les termes « dessus », « dessous », « supérieur », « inférieur », etc., ou à des qualificatifs d'orientation, tels que les termes « horizontal », « vertical », « latéral », etc., il est fait référence à l'orientation des figures correspondantes, étant entendu que, dans la pratique, les dispositifs et assemblages décrits peuvent être orientés différemment.

De même lorsqu'on indique qu'un élément est situé au droit d'un autre élément, cela signifie que ces deux éléments sont situés sur une même ligne perpendiculaire au plan principal dans lequel s'étend principalement une face du substrat, c'est-à-dire sur une même ligne orientée verticalement sur les figures. Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat.

Les termes « sensiblement », « environ », « de l'ordre de » signifient « à 10% près, de préférence à 5% près » ou, lorsqu'il s'agit d'une orientation angulaire, « à 10° près ». Ainsi, une direction sensiblement normale à un plan signifie une direction présentant un angle de 90±10° par rapport au plan.

Une portion ou un élément qualifié de « sacrificiel », signifie que cet élément est destiné à être « sacrifié », c'est-à-dire retiré lors d'une étape ultérieure de procédé.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants. De même, une couche à base de GaN comprend typiquement du GaN et des alliages d'AIGaN ou d'InGaN.

Le terme « matériau III-V » fait référence à un semi-conducteur composé d'un ou plusieurs éléments de la colonne III et de la colonne V du tableau périodique de Mendeleïev. On compte parmi les éléments de la colonne III le bore, le gallium, l'aluminium ou encore l'indium. La colonne V contient par exemple l'azote, l'arsenic, l'antimoine et le phosphore.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée S_{A:B}.

Un repère, de préférence orthonormé, comprenant les axes x, y, z est représenté en figure 1. Ce repère est applicable par extension aux autres figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base XY. Ainsi, une couche présente typiquement une épaisseur selon z, lorsqu'elle s'étend principalement le long d'un plan XY, et un élément en saillie, par exemple une tranchée d'isolation, présente une hauteur selon z. Les termes relatifs « sur », « sous », « sous-jacent » se réfèrent préférentiellement à des positions prises selon la direction z.

Les étapes du procédé telles que revendiquées s'entendent au sens large et peuvent éventuellement être réalisées en plusieurs sous-étapes.

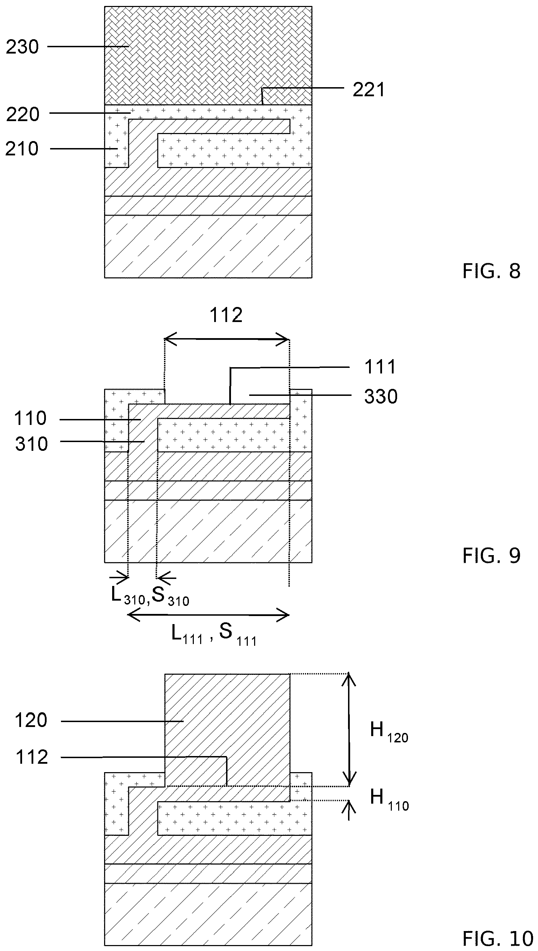

Un exemple de procédé de réalisation va maintenant être décrit en référence aux figures 1 à 10. Ce procédé permet d'obtenir la structure illustrée en figure 10, et qui comprend une couche 120 en matériau III-V présentant une forte épaisseur selon la direction Z du repère orthogonal XYZ illustré en figure 1.

La figure 1 illustre un empilement 1 comprenant une couche cristalline d'un matériau III-V dite couche de germination 100 et une première couche de masquage 210 surmontant la couche de germination 100.

La couche de germination 100 est par exemple faite ou est à base de GaN. Elle présente une face supérieure 101 qui s'étend principalement dans un plan XY du repère orthogonal XYZ.

La première couche de masquage 210 peut par exemple être réalisée en SiN. Elle peut être déposée par dépôt chimique en phase vapeur CVD (acronyme de « Chemical Vapor Déposition »).

Avantageusement, l'empilement 1 comprend également un substrat 10 pour supporter mécaniquement la couche de germination 100. Ce substrat 10 peut également être désigné support ou substrat de support. Ce substrat 10 est par exemple à base de silicium ou est fait de silicium pour réduire les coûts et pour faciliter la compatibilité du procédé avec les équipements et technologies usuels de l'industrie microélectronique. Dans ce dernier cas, il peut se présenter sous forme d'une plaquette également désignée wafer, dont le diamètre est par exemple de 200 mm ou 300 mm. Le substrat 10 peut également être en saphir-ou encore en SiC.

Dans certains cas, on peut prévoir de disposer, entre le substrat 10 et la couche de germination 100 une couche tampon 20, également désignée couche de nucléation. Cette couche tampon 20 peut être n'importe quelle couche connue de l'homme du métier permettant la nucléation et la croissance du matériau constituant la couche de germination 100. La couche tampon 20 est de préférence à base d'AIN. Elle peut être alternativement à base d'autres nitrures métalliques de type III-N, par exemple à base d'AIGaN. En outre, cette couche tampon 20 peut servir à éviter des réactions non souhaitées entre le substrat 10 et la couche de germination 100. Par exemple, si le substrat 10 est en Si et la couche de germination 100 est en GaN, il est nécessaire de prévoir une couche tampon 20, par exemple une couche d'AIN, afin d'éviter l'apparition du phénomène gravure par fusion, dit de « meltback etching » en langue anglaise qui apparaît du fait de la haute réactivité entre le silicium et le gallium à haute température.

Comme illustré en figure 2, une étape comprend la réalisation d'au moins une première ouverture traversante 310, réalisée dans la couche de masquage 210 de sorte à exposer une partie 102 de la face supérieure 101 de la couche de germination 100.

Cette première ouverture 310 peut être formée en procédant tout d'abord à une étape de lithographie UV (ultra-violet) ou DUV (acronyme de Deep UV en anglais, soit UV lointain), de lithographie par faisceau électronique, ou de NIL (acronyme de « Nanoimprint lithography » signifiant lithographie par nanoimpression), puis par exemple à une étape de gravure anisotrope, cette gravure pouvant être une gravure sèche ou humide. Par exemple, il peut s'agir d'une étape de gravure sèche en chimie chlorée ou fluorocarbonée.

Comme illustré en figure 2 également, on prévoit ensuite le dépôt d'une couche sacrificielle 30 qui recouvre la face supérieure 211 de la couche de masquage 210 et qui emplit l'ouverture 310, de préférence qui remplit entièrement l'ouverture 310. De préférence, cette couche sacrificielle 30 vient au contact de la face supérieure 101 de la couche de germination 100.

La couche sacrificielle 30 peut être réalisée en SiO₂, SiN, poly Si, SiGe, TiN ou à base d'au moins l'un de ces matériaux. Le dépôt de cette couche sacrificielle 30 peut dans un premier temps se faire pleine plaque, par dépôt chimique en phase vapeur, connu sous le terme anglais de « Low Pressure Chemical Vapor Déposition » (LPCVD), ou par dépôt chimique en phase vapeur assisté par plasma, connu sous le terme anglais de « Plasma-enhanced chemical vapor déposition » (PECVD).

Comme illustré en figure 3, la couche sacrificielle 30 est ensuite gravée de sorte à ce que cette couche s'étende sur une partie seulement de la première couche de masquage 210, et ce à partir de l'ouverture 310.

Plus précisément, sur une même plaque correspondant à la structure illustrée en figure 1, après sa gravure, la couche sacrificielle 30 forme des ilots disjoints, chaque îlot s'étendant depuis au moins une ouverture 310 formée dans la première couche de masquage 210.

Autrement dit et comme illustré sur les figures, selon cet exemple de réalisation, chaque îlot s'étend depuis une unique ouverture 310 formée dans la première couche de masquage 210.

Selon un mode de réalisation alternatif, chaque îlot formé par la couche sacrificielle 30 s'étend depuis plusieurs ouvertures 310 formées par la première couche de masquage 210.

Naturellement, la structure illustrée en figure 3 peut être reproduite de nombreuses fois à la surface de la couche de germination 100. Ainsi, à l'issue de l'étape illustrée en figure 3, une pluralité de couches sacrificielles disjointes seront présentes sur une même plaque. Les étapes qui seront décrites par la suite seront appliquées à chacune de ces couches sacrificielles.

Comme illustré en figure 4, une deuxième couche de masquage 220 est ensuite déposée sur la face supérieure 211 de la première couche de masquage 210 et sur la face supérieure 31 de la couche sacrificielle 30. La deuxième couche de masquage 220 présente une face supérieure 221 qui s'étend principalement dans un plan parallèle au plan XY du repère orthogonal XYZ.

Comme la première couche de masquage 210, la deuxième couche de masquage 220 peut être réalisée en SiN, ou d'un autre matériau, qui ne sera pas gravé lors du retrait de la couche sacrificielle. Elle peut être déposée par dépôt chimique en phase vapeur CVD. Avantageusement, la deuxième couche de masquage 220 est faite du même matériau que la première couche de masquage 210. Cela permet d'obtenir un environnement homogène pour la croissance de la première couche épitaxiée qui sera décrite par la suite et donc d'obtenir une croissance homogène. Cela permet également de simplifier le processus de fabrication.

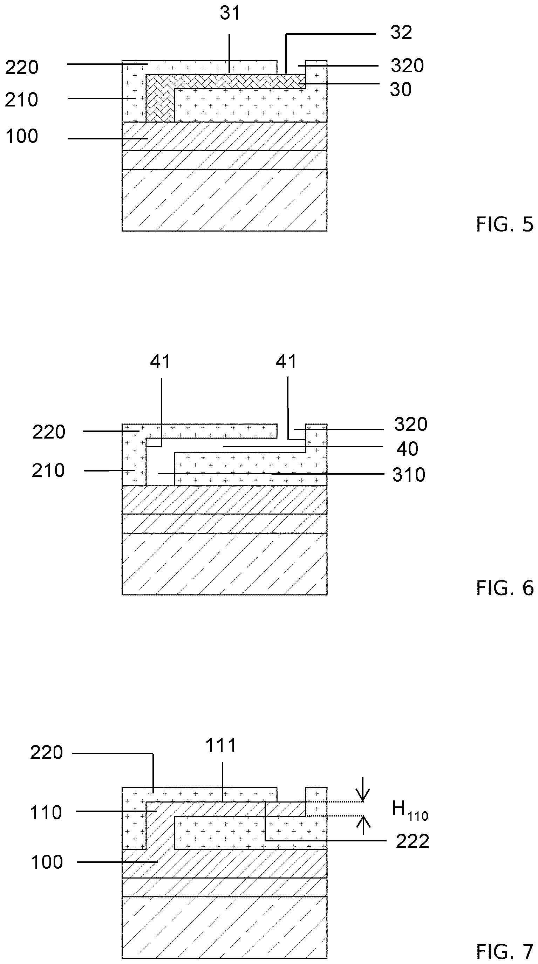

Comme illustré en figure 5, une étape comprend la fabrication d'au moins une deuxième ouverture 320 réalisée dans la deuxième couche de masquage 220 de sorte à exposer une partie 32 de la face supérieure 31 de la couche sacrificielle 30.

La deuxième ouverture 320 peut être formée en procédant tout d'abord à une étape de lithographie UV ou DUV, de lithographie par faisceau électronique, ou encore de NIL, puis par exemple à une étape de gravure anisotrope, cette gravure pouvant être une gravure sèche ou humide. Par exemple, il peut s'agir d'une étape de gravure sèche en chimie chlorée ou fluorocarbonée.

Comme illustré à la figure 6, une étape comprend ensuite le retrait de la couche sacrificielle 30 tout en conservant la première couche de masquage 210 et la deuxième couche de masquage 220.

Le matériau constituant la couche sacrificielle 30 doit donc être choisi de telle sorte qu'il présente une bonne sélectivité à la gravure par rapport au matériau de la première couche de masquage 210 et au matériau de la deuxième couche de masquage 220 lors du retrait de ladite couche sacrificielle 30. Si la première couche de masquage 210 ou la deuxième couche de masquage 220 est réalisée, comme donné en exemple, en SiN, il est donc exclu de réaliser la couche sacrificielle 30 dans ce même matériau. Par exemple, si la première couche masquage 210 ou la deuxième couche de masquage 220 est en SiN, on peut prévoir de réaliser la couche sacrificielle 30 à base de SiO₂ ou en SiO₂ uniquement.

Le retrait de la couche sacrificielle 30 sélectivement par rapport à la première couche de masquage 210 et à la deuxième couche de masquage 220 peut se faire par gravure isotrope humide à partir de la deuxième ouverture 320. Il est possible d'utiliser une solution de HF pour une couche sacrificielle en SiO₂. Préférentiellement, la gravure de la couche sacrificielle 30 est sélective par rapport à la couche de germination 100. Une gravure sèche isotrope est également possible.

Ce retrait permet de former une cavité 40 destinée à la croissance d'une première couche épitaxiée 110 du matériau III-V telle qu'illustrée à la figure 7. Cette cavité 40 s'étend depuis la couche de germination 100 au travers de la première ouverture 310. Ainsi cette croissance se fait à partir de la partie 102 de la face supérieure 101 de la couche de germination 100 exposée grâce à la première ouverture 310.

La première couche épitaxiée 110 peut être fabriquée par épitaxie en phase vapeur à précurseurs organométalliques MOVPE (acronyme de « MetalOrganic Vapour Phase Epitaxy »), parfois appelée dépôt chimique en phase vapeur à précurseurs organométalliques MOCVD (acronyme de de « MetalOrganic Chemical Vapor Déposition »). La source de gallium sous forme de précurseur organométallique (précurseur III) peut typiquement être du triméthyl-gallium (TMGa) ou du triéthyl-gallium (TEGa). La source d'azote peut typiquement être de l'ammoniaque (NH₃) (précurseur V). La température de croissance est de préférence supérieure à 600°C, par exemple de l'ordre de 1000°C. La pression de gaz au sein du réacteur de croissance est par exemple de l'ordre de 100 Torr (1 Torr = 133 322 Pa = 133 322 kg.m⁻¹.s⁻²). La croissance se fait de préférence sous atmosphère neutre et/ou réductrice, typiquement par ajout d'azote N₂ et/ou de dihydrogène H₂. Les flux des différents gaz pourront être adaptés de façon connue par l'homme du métier, en fonction notamment du volume du réacteur.

La première couche épitaxiée 110 peut alternativement être fabriquée par épitaxie par jets moléculaires MBE (acronyme anglais de « Molecular Beam Epitaxy »), par épitaxie en phase vapeur à précurseurs gazeux chlorés HVPE (acronyme de « Hydride Vapour Phase Epitaxy ») ou par dépôt chimique en phase vapeur CVD.

Lors de la croissance de la première couche épitaxiée 110, cette dernière est bloquée verticalement par le plafond de la cavité 40, qui est formé par la face inférieure 222 de la deuxième couche de masquage 220. La première couche épitaxiée 110 croît donc de manière privilégiée latéralement, selon une direction parallèle au plan XY. Cela permet d'atteindre une vitesse de croissance élevée et ce sans augmenter l'épaisseur de la première couche épitaxiée 110. La face supérieure de la première couche épitaxiée 111 s'étend principalement dans un plan parallèle au plan XY.

Dans le mode de réalisation avantageux dans lequel chaque îlot de la couche sacrificielle 30 s'étend depuis une unique ouverture 310 formée dans la première couche de masquage 210, la cavité 40 ne communique qu'avec une seule ouverture 310 dans la couche de masquage 210. La croissance de la première couche épitaxiée 110 dans une cavité 40 se fait donc à partir d'une seule partie 102 de la face supérieure 101 de la couche de germination 100, comme illustré en figure 7. Pour une cavité 40, il y a ainsi un unique front de croissance, ou front d'épitaxie. Cela évite la présence d'un voire plusieurs joints de coalescence dus à la rencontre de fronts d'épitaxie venant de différentes parties 102 de la face supérieure 101. Un tel joint de coalescence pourrait en effet engendrer des défauts structuraux dans la première couche épitaxiée 110. Ce mode de réalisation permet donc de réduire encore le nombre de défauts dans la première couche épitaxiée 110.

Avantageusement, la deuxième ouverture 320 expose une partie 32 de la face supérieure 31 de la couche sacrificielle 30 éloignée de la zone de la couche sacrificielle 30 située à l'aplomb de la première ouverture 310. Préférentiellement, cette partie 32 exposée de la couche sacrificielle 30 est située à l'extrémité opposée de la face supérieure 31 de la couche sacrificielle 30 par rapport à la zone de la couche sacrificielle 30 à l'aplomb de la première ouverture 310. Plus la deuxième ouverture 320, qui permet l'accès à la cavité 40 laissée après le retrait de la couche sacrificielle 30 pour la croissance de la première couche épitaxiée 110, est éloignée de la première ouverture 310, qui permet l'accès à la couche de germination 100, plus on augmente la proportion de la première couche épitaxiée 110 qui croit en étant confinée dans toutes les directions de l'espace, hormis dans le plan XY. Réaliser la deuxième ouverture 320 à l'extrémité opposée de la face supérieure 31 de la couche sacrificielle 30 par rapport à la zone de la couche sacrificielle 30 à l'aplomb de la première ouverture 310 permet donc de faire croître la première couche épitaxiée 110 de façon confinée dans sa quasi-intégralité.

Dans le procédé selon l'invention, l'amorce de la croissance se fait au niveau de la première ouverture 310 exposant la partie 102 de la face supérieure 101 de la couche de germination 100, et non sur la totalité de la face supérieure 101 de la couche de germination 100. La superficie de la zone d'amorce est donc limitée. Or, comme mentionné plus haut, la couche de germination 100, dont la croissance a été effectuée à partir d'un substrat typiquement de silicium, présente une très grande densité de dislocations ou induit une grande densité de dislocations à l'interface Si / matériau III-V. Limiter la superficie de la zone d'amorce permet donc de limiter le nombre de défauts susceptibles de se propager dans la première couche épitaxiée 110. En outre, la croissance de la première couche épitaxiée 110 étant essentiellement dans le plan XY, cela permet de réduire, voire de supprimer la propagation des dislocations dans cette première couche épitaxiée 110. Plus précisément, les dislocations formées à l'interface entre la couche de germination 100 et le matériau épitaxié dans la première ouverture 310, ainsi que les dislocations s'étendant dans cette première ouverture 310, ne se propagent pas latéralement dans le plan XY et donc dans la première couche épitaxiée 110. En outre, la forme en coude donnée à la cavité 40 par le procédé selon l'invention permet de limiter la propagation des dislocations. Ainsi, la première couche épitaxiée 110 présente une très faible densité de dislocations.

Comme illustré à la figure 9, une étape comprend ensuite le retrait d'une partie de la deuxième couche de masquage 220 permettant d'exposer une partie 112 de la face supérieure 111 de la première couche épitaxiée 110, formant ainsi une troisième ouverture 330. Les dimensions de ce retrait définissent les dimensions dans le plan XY de la deuxième couche épitaxiée 120. Préférentiellement, la zone de la face supérieure 111 de la première couche épitaxiée 110 à l'aplomb de la première ouverture 310 n'est pas exposée par l'ouverture 330. Avantageusement, et comme cela sera détaillé par la suite en référence aux figures 26 et 27, cela permet de de faciliter une reprise de contact au niveau de la première couche épitaxiée, depuis une face avant du dispositif opposée à cette première couche épitaxiée.

Suite à la formation de l'ouverture 330, on prévoit une étape d'épitaxie illustrée à la figure 10 permettant de réaliser la deuxième couche épitaxiée 120. Cette deuxième couche épitaxiée 120 peut être fabriquée par les mêmes méthodes que la première couche épitaxiée 110. La croissance est réalisée à partir de la partie 112 de la face supérieure 111 de la première couche épitaxiée 110. Comme mentionné précédemment, cette première couche épitaxiée 110 présente une faible densité de dislocations. De ce fait, peu de dislocations sont propagées à la deuxième couche épitaxiée 120 lors de sa croissance. La deuxième couche épitaxiée 120 présente donc elle-même une très faible densité de dislocations.

De préférence, les matériaux et précurseurs utilisés pour les croissances des première 110 et deuxième 120 couches épitaxiées sont identiques. On notera néanmoins que l'on peut ajouter des dopants dans une partie ou dans l'intégralité de l'une seulement de ces deux couches 110, 120. Tel est par exemple le cas si l'on souhaite réaliser dans tout ou partie de la première couche épitaxiée un dopage d'un type P ou N, et que l'on souhaite réaliser dans tout ou partie de la deuxième couche épitaxiée un dopage inverse. De même, telle est également le cas si l'on souhaite former une zone active comprenant des puits quantiques au sein de la deuxième couche épitaxiée.

Selon un mode de réalisation, selon une coupe parallèle au plan XY, la première ouverture 310 présente une dimension dite L₃₁₀ et la face supérieure 111 de la première couche épitaxiée 110 présente une dimension dite L₁₁₁, avec L₁₁₁>5*L₃₁₀, de préférence L₁₁₁>10*L₃₁₀ et de préférence L₁₁₁>20*L₃₁₀. Les dimensions L₁₁₁ et L₃₁₀ sont les dimensions maximales de ces ouvertures. Ainsi, pour des ouvertures présentant une forme circulaire dans le plan XY, ces dimensions correspondent au diamètre. Pour des ouvertures présentant une forme polygonale dans le plan XY, ces dimensions correspondent à la plus grande diagonale. Ainsi, la dimension de la première ouverture est très inférieure à la dimension de la première couche épitaxiée. Cela permet d'éviter la propagation des dislocations depuis la face supérieure 102 de la couche de germination 100 jusque dans la première couche épitaxiée 110.

Selon un mode de réalisation, selon une coupe parallèle au plan XY, la première ouverture 310 présente une surface dite S₃₁₀ et la face supérieure 111 de la première couche épitaxiée 110 une surface dite S₁₁₁, avec S₁₁₁>5*S₃₁₀, de préférence S₁₁₁>10*S₃₁₀ et de préférence S₁₁₁>20*S₃₁₀.

Selon un mode de réalisation, la première couche épitaxiée 110 présente une épaisseur H₁₁₀ et la deuxième couche épitaxiée 120 présente une épaisseur H₁₂₀, avec H₁₂₀>1,5*H₁₁₀, de préférence H₁₂₀>3*H₁₁₀ et de préférence H₁₂₀>5*H₁₁₀. Ainsi, l'épaisseur de la deuxième couche épitaxiée 120 est très supérieure à l'épaisseur de la première couche épitaxiée 110. Cela permet d'éviter la propagation des dislocations dans la première couche épitaxiée 110, puis d'obtenir une épaisseur importante de matériau III-V grâce à la deuxième couche épitaxiée 120.

Les figures 8, 11 et 12 illustrent un exemple optionnel.

L'étape illustrée en figure 8 fait suite aux étapes décrites en référence aux figures 1 à 7. Comme illustré à la figure 8, après la croissance de la première couche épitaxiée 110 et avant la croissance de la deuxième couche épitaxiée 120, une troisième couche de masquage 230 est déposée sur la face supérieure 221 de la deuxième couche de masquage 220. De préférence, cette troisième couche de masquage 230 est également déposée avant la réalisation de l'ouverture 330.

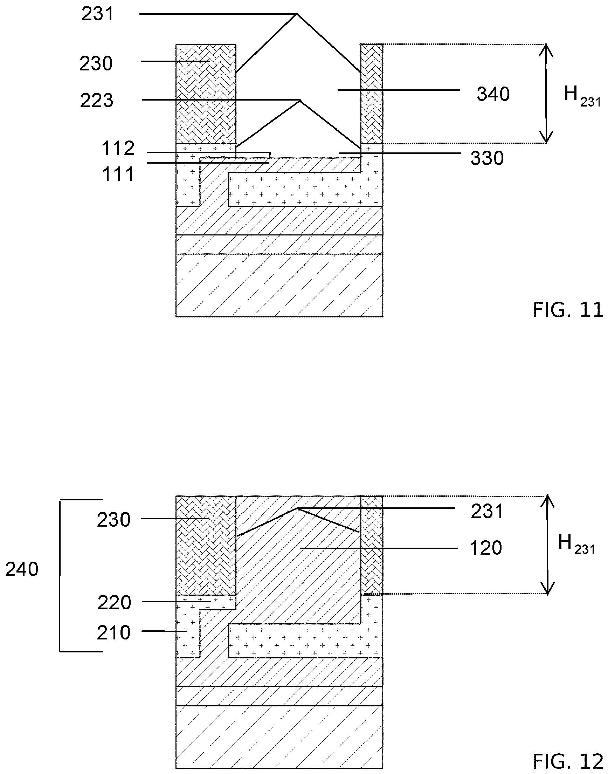

L'étape illustrée en figure 11 fait suite à l'étape illustrée en figure 8. Comme illustré à la figure 11, dans ce mode de réalisation, une étape comprend ensuite le retrait d'une partie de la troisième couche de masquage 230 permettant au moins d'exposer la partie 112 de la face supérieure 111 de la première couche épitaxiée 110 et formant une ouverture 340. Préférentiellement, la quatrième ouverture 340 se trouve exactement à l'aplomb de la troisième ouverture 330, comme illustré à la figure 11. Avantageusement, la fabrication de la troisième ouverture 330 et celle de la quatrième ouverture 340 s'effectuent simultanément.

Comme illustré en figure 12, la croissance de la deuxième couche épitaxiée 120 est alors limitée dans le plan XY par les flancs 231de la troisième couche de masquage 230. Cela permet de contraindre latéralement la croissance, donc de contrôler plus précisément les dimensions de la deuxième couche épitaxiée 120 et par voie de conséquence de mieux contrôler les dimensions du dispositif vertical confectionné à partir de cette deuxième couche épitaxiée 120. Cela permet donc d'éviter une croissance non contrôlée latéralement de la deuxième couche épitaxiée 120. Notamment, cela permet d'éviter que des deuxièmes couches 120, adjacentes mais que l'on souhaite disjointes car destinées à former des composants disjoints sur une même plaque, n'entrent au contact. La couche de masquage 230 fait ainsi office d'isolant entre des deuxièmes couches 120 adjacentes.

Selon un mode de réalisation, les flancs 231 de la troisième couche de masquage 230 présentent une hauteur H₂₃₁ telle que H₂₃₁≥H₁₂₀.

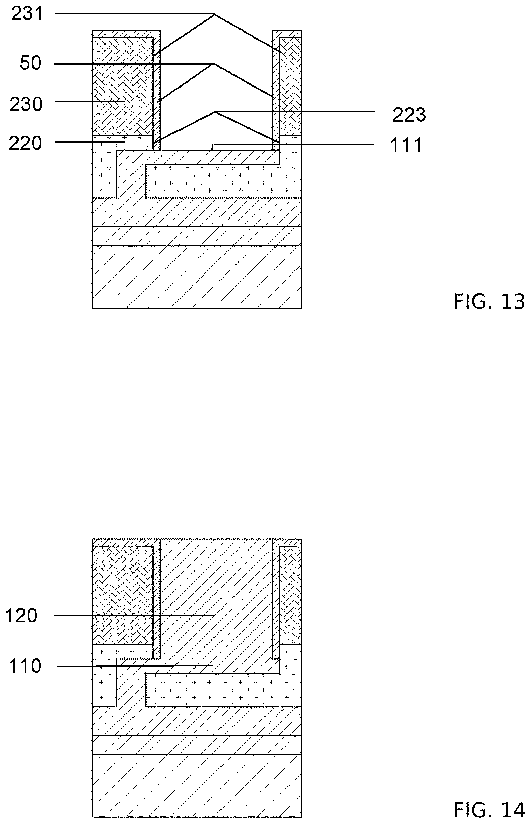

Les figures 13 et 14 illustrent un mode de réalisation optionnel. Selon ce mode de réalisation, une couche de protection 50 est déposée sur les flancs 231 de la troisième couche de masquage 230 et sur les flancs 223 de la deuxième couche de masquage 220 avant la croissance de la deuxième couche épitaxiée 120. Le dépôt de cette couche de protection 50 peut dans un premier temps être réalisé pleine plaque, par LPCVD, par PECVD, par dépôt de couche atomique ALD (acronyme anglais de « Atomic Layer Déposition ») ou encore par dépôt de couche atomique assisté par plasma PEALD (acronyme anglais de « Plasma Enhanced Atomic Layer Déposition »). La partie de la couche de protection 50 recouvrant la face supérieure 111 de la première couche épitaxiée 110 est ensuite retirée pour exposer cette dernière. Ce retrait s'effectue préférentiellement par gravure sèche ou ionique. Avantageusement, on prévoit une étape subséquente de nettoyage de la surface supérieure 111 de la première couche épitaxiée 110. La couche de protection 50 fait office de barrière empêchant la diffusion d'atomes de la deuxième couche de masquage 220 ou de la troisième couche de masquage 230 dans la deuxième couche épitaxiée 120 lors de la croissance de cette dernière. Cela permet d'éviter un dopage non intentionnel de la deuxième couche épitaxiée 120. Préférentiellement, la couche de protection 50 est en Al₂O₃.

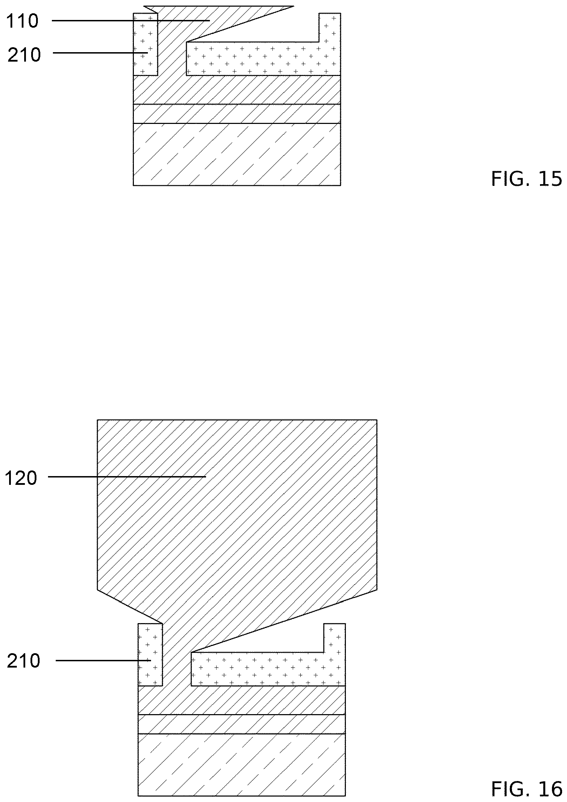

Les figures 15 et 16 illustrent un procédé non revendiqué, différent de celui décrit ci-dessus et qui ne prévoit pas de faire croître la première couche épitaxiée au sein d'une cavité présentant un plafond formé par la face inférieure 222 de la deuxième couche de masquage 220. Dans ce cas, la croissance de la première couche épitaxiée 110 n'est pas bloquée verticalement et n'est donc pas contrainte à progresser dans le plan XY. Elle croit donc à distance de la première couche de masquage 100. Cela ne permet pas de bloquer de façon satisfaisante les dislocations dans la deuxième couche épitaxiée 120.

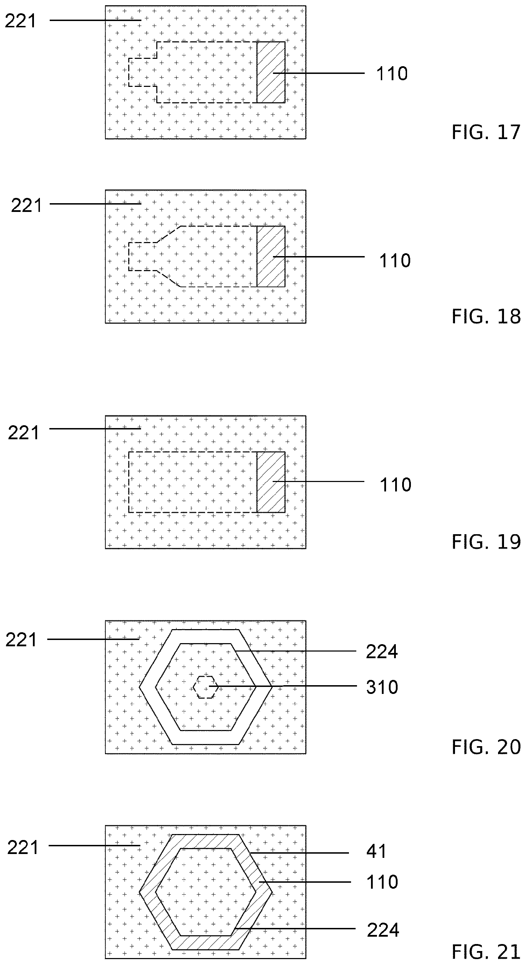

Les figures 17 à 21 illustrent différentes formes de cavité et de forme de couches obtenues par épitaxie. Chacune de ces figures illustre, en vue du dessus, une structure obtenue à l'issue de l'étape de formation de la première couche épitaxiée 110 et avant la réalisation de l'ouverture 330 dans la deuxième couche de masquage 220. Dans ces exemples, pour faciliter l'explication, on considère que la première 210 et la deuxième 220 couches de masquage 220 sont transparentes. Les textures utilisées dans ces figures permettent ainsi d'observer la première couche épitaxiée 110 soit directement, soit par transparence à travers la deuxième couche de masquage 220.

Selon un mode de réalisation représenté à la figure 17, la cavité 40 a, dans le plan XY, la forme de deux rectangles juxtaposés, l'un à l'aplomb de la première ouverture 310 et le deuxième, de dimensions supérieures, s'étendant à partir de l'un des bords du premier rectangle. Cette forme permet de guider la croissance de la première couche épitaxiée 110 dans une première zone encore très confinée dans le plan XY, avant de laisser celle-ci s'étendre davantage latéralement, assurant ainsi une très faible propagation des dislocations.

Selon un autre mode de réalisation illustrée en figure 18, la cavité 40 présente, toujours dans le plan XY, une forme d'entonnoir s'élargissant en s'éloignant de la première ouverture 310. Cette forme permet de guider la croissance de la première couche épitaxiée 110 dans une première zone encore très confinée dans le plan XY, puis dans une deuxième zone de largeur croissante. Cela a pour effet d'éviter un changement de dimension brutal et la génération de défauts de croissance qui y est liée.

Selon un autre mode de réalisation représenté à la figure 19, la forme de la couche sacrificielle 30 permet de donner à la cavité 40 et donc à la première couche épitaxiée 110 une forme rectangulaire dans le plan XY, comme.

Selon d'autres modes de réalisation illustrés en figures 20 et 21, la croissance de la première couche épitaxiée 110 se fait dans toutes les directions du plan XY. De préférence, la première ouverture 310 est alors au centre de la cavité 40 ou tout au moins à distance des bords de la cavité 40. Ainsi, la première couche épitaxiée 110 peut croître à partir de la première ouverture 310 selon plusieurs directions du plan XY, de préférence selon toutes les directions du plan XY. Par exemple la cavité 40 présente une forme hexagonale selon une section XY. Elle peut également présenter une forme circulaire selon une section XY. La première couche épitaxiée 110 croît jusqu'à entrer au contact des bords 41 de la cavité 40 ce qui lui impose sa forme selon une section XY. Dans ces modes de réalisation où la croissance de la première couche épitaxiée 110 se fait dans toutes les directions du plan XY, il est nécessaire que la portion 224 de la deuxième couche de masquage 220 confinant la croissance de la première couche épitaxiée 110 dans la direction z et le reste de la deuxième couche de masquage 220 soient continus afin d'assurer le maintien de la portion 224 dans sa position initiale lors du retrait de la couche sacrificielle 30. Ainsi, préférentiellement, on prévoit que la portion 224 de la deuxième couche de masquage 220 soit reliée au reste de la deuxième couche de masquage 220 par des parties de la deuxième couche de masquage 220 non représentées sur les figures 20 et 21 par souci de clarté. Ainsi, la croissance est effectuée de sorte à former des ponts qui relient les ilots centraux et les régions périphériques qui entourent les ilots.

Un autre aspect de l'invention concerne des composants pouvant être obtenus par le procédé objet de l'invention ainsi que d'autres étapes de fabrication usuelles en microélectronique. Les figures 22 à 27 illustrent ces composants ainsi que des étapes qui permettent réalisation.

Les figures 22 à 24 illustrent un exemple pour réaliser un premier composant. Ce composant comporte une couche de germination 100 en un matériau III-V, une première couche épitaxiée 110 du même matériau présentant une forme de coude dans un plan normal au plan XY et une deuxième couche épitaxiée 120 présentant une forte épaisseur selon la direction z du repère orthogonal XYZ illustré en figure 22, la couche de germination 100 et la première couche épitaxiée 110 d'une part, et la première couche épitaxiée 110 et la deuxième couche épitaxiée 120 d'autre part, étant en contact. La couche de germination 100, la première couche épitaxiée 110 et la deuxième couche épitaxiée 120 forment un ensemble 130 constitué du même matériau III-V.

Selon un mode de réalisation, le composant présente une première zone dopée 1001, de dopage de type N ou de type P. Cette zone dopée 1001 s'étend dans une partie au moins de la première couche épitaxiée 110, de préférence, depuis la face de la première couche épitaxiée au contact de la première couche masquage 210. Cette zone dopée 1001 peut s'étendre sur une partie seulement ou sur l'intégralité de l'épaisseur de la première couche épitaxiée 110. On peut également prévoir que cette zone dopée 1001 s'étende également dans une partie de la deuxième couche épitaxiée 120 qui s'étend depuis la première couche épitaxiée 110.

La deuxième couche épitaxiée 120 présente une deuxième zone dopée 1002, de dopage de l'autre type parmi le type N ou le type P. La deuxième zone dopée 1002 est située à une extrémité supérieure de la deuxième couche épitaxiée 120 opposée à une extrémité inférieure qui est au contact de la première couche épitaxiée 110. La deuxième zone dopée 1002 s'étend de préférence depuis la surface 121 de la deuxième couche épitaxiée 120. Préférentiellement, la première zone dopée 1001 et la deuxième zone dopée 1002 présentent des épaisseurs dans la direction Z comprises entre 2 µm et 20 µm, de préférence entre 5 et 15 µm, et entre 50 nm et 2 µm, de préférence entre 100 nm et 500 nm, respectivement.

Le composant comporte une première électrode 2001 à la surface de la deuxième zone dopée 1002. De manière parfaitement classique, cette première électrode 2001 peut être formée en déposant un métal sur la surface 121 de la deuxième couche épitaxiée 120. Ce dépôt peut être conforme. On effectue ensuite un aplanissement de cette couche, par exemple par polissage mécanochimique (CMP). Avantageusement, on prévoit que cet aplanissement forme une surface plane formée par la première électrode 2001 et par une quatrième couche de masquage 240 entourant la deuxième couche épitaxiée 120. La quatrième couche de masquage 240 peut éventuellement être constituée de plusieurs couches de masquage, comme indiqué ci-dessus en référence à la figure 12, où la quatrième couche de masquage 240 est constituée de la deuxième couche de masquage 220 et de la troisième couche de masquage 230. Le résultat de ces étapes est illustré en figure 23.

Le composant comporte une deuxième électrode 2002 au contact de la première zone dopée 1001. Pour cela, on peut effectuer les étapes suivantes:
- fixation d'un substrat poignée 5000 sur la face comportant la première électrode 2001,
- retournement de l'empilement de sorte à ce que le substrat 10 soit orienté vers le haut,
- retrait du substrat 10, de la couche tampon 20 optionnelle et de la couche de germination 100. Ces retraits peuvent être par exemple opérés par CMP, par amincissement mécanique ou meulage (technique connue sous le terme anglais de « grinding ») ou encore par gravure sèche ou humide.
- dépôt d'une électrode métallique 2002 sur la première zone dopée 1001.

Le résultat obtenu à l'issue de ces étapes est illustré en figure 24. Il permet par exemple la réalisation d'une diode P-N.

La figure 25 illustre un autre composant, typiquement une LED. Selon ce mode de réalisation, le composant comporte une zone active 3000. Cette zone active 3000 comprend typiquement une pluralité de puits quantiques. Classiquement, dans ces couches, un électron va se recombiner avec un trou en émettant un photon d'énergie donnée. Ces photons forment le rayonnement lumineux de longueur d'onde λ. La zone active 3000 comprend par exemple ou est constituée par un empilement d'une ou plusieurs couches émissives formant chacune un puits quantique, par exemple à base de GaN, InN, InGaN, AIGaN, AIN, AlInGaN, GaP, AIGaP, AlInGaP, AIGaAs, GaAs, InGaAs, AlInAs, ou d'une combinaison d'un ou plusieurs de ces matériaux. De préférence le matériau de la deuxième couche épitaxiée 120 est à base du matériau de la première couche épitaxiée 110. , i.e., cela signifie que le matériau de la deuxième couche épitaxiée 120 est identique au matériau de la première couche épitaxiée 110 à l'exception des dopants incorporés au niveau de la zone active 3000 comprenant les puits quantiques. A titre de variante, la zone active 3000 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³.

La zone active 3000 peut être formée lors de la croissance épitaxiale de la deuxième couche épitaxiée 120. À l'exception de ce dopage, les étapes de réalisation de ce composant sont alors identiques à celles décrites en référence aux figures 22 à 24. Le composant obtenu forme ainsi une LED.

Selon un autre exemple illustré en figures 26 et 27. Dans ce mode de réalisation, la première zone dopée 1001 présente une forme telle qu'elle permet une reprise de contact à son aplomb. Plus précisément, dans ce mode de réalisation, la deuxième électrode 2002 a été réalisée dans une ouverture 350 elle-même fabriquée dans une quatrième couche de masquage 240 entourant la deuxième couche épitaxiée 120. Il est parfaitement envisageable qu'en lieu et place de la quatrième couche de masquage 240, le confinement de la deuxième couche épitaxiée 120 soit assuré par une deuxième 220 et une troisième couches de masquage 230 comme décrit ci-dessus en référence aux figures 12 et 14. Cette ouverture 350 forme ainsi un via qui rend accessible la première zone dopée 1001 depuis la face opposée de la structure, par exemple depuis une face supérieure 232 de la quatrième couche de masquage 240. Cette reprise de contact s'effectue dans une zone 113 de la première couche épitaxiée 110 qui forme saillie par rapport aux flancs de la deuxième couche épitaxiée 120, selon une projection de ces deux couches sur un plan XY. Cette zone 113 est illustrée en figure 27. La dimension de cette zone 113, prise dans le plan XY est suffisante pour permettre une reprise de contact tout en conservant une portion du matériau électriquement isolant de la couche de masquage 240/230, ceci afin d'assurer une bonne isolation entre l'électrode 2002 et la deuxième couche épitaxiée 120. Une telle reprise de contact permet que les deux électrodes du dispositif se trouvent du même côté du dispositif. Cela peut être utile dans certaines architectures et facilite le traitement des plaques sur lesquelles se trouvent le dispositif.

Selon un autre mode de réalisation non illustré, le composant comprend une unique zone dopée, de dopage de type N ou de type P, s'étendant dans une partie ou l'intégralité de la deuxième couche épitaxiée 120, depuis la surface 121 de la deuxième couche épitaxiée. On peut également prévoir que cette unique zone dopée s'étende également dans une partie de la première couche épitaxiée 110 qui s'étend depuis la deuxième couche épitaxiée 120. Le composant ainsi obtenu peut être destiné à la fabrication d'une diode Schottky, d'une diode n-i-n, p-i-n ou p-i-p ou encore d'un transistor MOSFET.

À travers les différents modes de réalisation décrits ci-dessus, il apparaît clairement que l'invention propose une solution efficace pour faire croître verticalement une couche épaisse de matériau III-V.

L'invention n'est pas limitée aux modes de réalisations précédemment décrits et s'étend à tous les modes de réalisation couverts par son esprit.

## Revendications

1. Procédé de croissance d'un matériau III-V comprenant :
• Une fourniture d'un empilement (1) comprenant une couche cristalline en matériau III-V dite couche de germination (100), une première couche de masquage (210) surmontant la couche de germination (100), la première couche de masquage (210) présentant au moins une première ouverture (310) exposant une partie (102) d'une face supérieure (101) de la couche de germination (100),
• Une formation d'au moins une couche sacrificielle (30) remplissant la première ouverture (310) et s'étendant depuis la première ouverture (310) sur au moins une première région (213) d'une face supérieure (211) de la première couche de masquage (210),
• Un dépôt d'une deuxième couche de masquage (220) recouvrant une face supérieure (31) de la couche sacrificielle (30) et recouvrant au moins une deuxième région (214) de la face supérieure (211) de la première couche de masquage (210), la deuxième région (214) étant non recouverte par la couche sacrificielle (30),
• Une formation d'au moins une deuxième ouverture (320) dans la deuxième couche de masquage (220) de sorte à rendre accessible une partie (32) de la face supérieure (31) de la couche sacrificielle (30),
• Un retrait de la couche sacrificielle (30) sélectivement par rapport à la première couche de masquage (210) et à la deuxième couche de masquage (220), de sorte à former au moins une cavité (40),
• Une croissance par épitaxie d'un matériau à base du matériau III-V à partir de la couche de germination (100) dans la première ouverture (310) et dans la cavité (40), de sorte à former au moins une première couche épitaxiée (110) s'étendant dans la première ouverture (310) et dans la cavité (40) et présentant une face supérieure (111) s'étendant principalement dans un plan XY,
• Une formation d'au moins une troisième ouverture (330) dans la deuxième couche de masquage (220) sur une portion permettant d'exposer une partie (112) de la face supérieure (111) l'au moins une première couche épitaxiée (110),
• Une croissance par épitaxie d'au moins un matériau à base du matériau III-V à partir de la première couche épitaxiée (110), la direction privilégiée de la croissance étant normale au plan XY, de sorte à former au moins une deuxième couche épitaxiée (120) s'étendant depuis l'au moins une première couche épitaxiée (110).

2. Procédé selon la revendication précédente, dans lequel selon une coupe parallèle au plan XY, la première ouverture (310) présente une dimension L310 et la face supérieure (111) de la première couche épitaxiée (110) présente une dimension L111, avec L111>5*L310, de préférence L111>10*L310 et de préférence L111>20*L310.

3. Procédé selon l'une quelconque des revendications précédentes, dans lequel la première couche épitaxiée (110) présente une épaisseur H110 et la deuxième couche épitaxiée (120) présente une épaisseur H120, avec H120>2*H110, de préférence H120>3*H110 et de préférence H120>5*H110, les épaisseurs H₁₂₀ et H₁₁₀ étant prises selon une direction Z perpendiculaire au plan XY.

4. Procédé selon l'une quelconque des revendications précédentes, comprenant, après la formation de la première couche épitaxiée (110) et avant la formation de la troisième ouverture (330) dans la deuxième couche de masquage (220), un dépôt d'une troisième couche de masquage (230) sur la deuxième couche de masquage (220), et une formation dans la troisième couche de masquage (230) d'au moins une quatrième ouverture (340) présentant des flancs (231) et configurée pour exposer une partie de la deuxième couche de masquage (220), les flancs (231) de la troisième couche de masquage (230) étant conservés lors de la croissance de la deuxième couche épitaxiée (120) à partir de la première couche épitaxiée (110).

5. Procédé selon la revendication précédente, dans lequel une couche de protection (50) est déposée au moins sur les flancs (231) de la troisième couche de masquage (230), et de préférence sur des flancs (223) définissant la troisième ouverture (330) de la deuxième couche de masquage (220), avant l'étape de croissance de la deuxième couche épitaxiée (120), cette couche de protection (50) recouvrant les flancs (231) de la troisième couche de masquage (230), et de préférence les flancs (223) de la deuxième couche de masquage (220), durant l'étape de croissance de la deuxième couche épitaxiée.

6. Procédé selon l'une quelconque des revendications 1 à 5, dans lequel la croissance de la première couche épitaxiée (110) se fait dans toutes les directions du plan XY, et dans lequel la première ouverture (310) est de préférence située à l'aplomb d'un centre de la cavité (40).

7. Procédé selon l'une quelconque des revendications précédentes, comprenant :
• un dopage parmi un dopage de type N ou de type P de la première couche épitaxiée (110),
• un dopage de l'autre type parmi un dopage de type N ou de type P d'une deuxième zone dopée (1002) de la deuxième couche épitaxiée (120), la deuxième zone dopée s'étendant depuis face supérieure (121) de la deuxième couche épitaxiée (120).

8. Procédé selon la revendication précédente, comprenant en outre :
• une réalisation d'une première électrode (2001) en contact électrique avec la deuxième couche épitaxiée (120),
• une réalisation d'une deuxième électrode (2002) en contact électrique avec la première couche épitaxiée (110).

9. Procédé selon la revendication précédente, dans lequel l'empilement forme une jonction PN.

10. Procédé selon la revendication 8, comprenant en outre une formation de puits quantiques au sein de la deuxième couche épitaxiée (120), de sorte à fabriquer une LED.

11. Procédé selon l'une quelconque des trois revendications précédentes prises en combinaison avec l'une quelconque des revendications 4 à 5, dans lequel la première électrode (2001) est déposée dans une cinquième ouverture (350) préalablement réalisée dans la troisième couche de masquage (230) et dans la deuxième couche de masquage (220) de sorte à exposer une partie de la face supérieure (111) de la première couche épitaxiée (110) et la rendre accessible depuis une face supérieure (232) la troisième couche de masquage (230).

12. Procédé selon l'une quelconque des revendications précédentes, dans lequel :
• la première couche de masquage (210) présente une pluralité de premières ouvertures (310) exposant chacune une partie (102) de la face supérieure (101) de la couche de germination (100),
• l'étape de formation d'au moins une couche sacrificielle (30) est effectuée de sorte à former une pluralité de couches sacrificielles (30), disjointes les unes des autres, remplissant chacune au moins une première ouverture (310),
• la deuxième couche de masquage (220) recouvre la pluralité de couches sacrificielles (30),
• l'étape de formation d'au moins une deuxième ouverture (320) est effectuée de sorte à rendre accessible une partie (32) de la face supérieure (31) de chacune des couches sacrificielles (30),
• l'étape de formation d'au moins une deuxième ouverture (320) est effectuée de sorte à former une pluralité de deuxièmes ouvertures (320), de sorte à rendre accessible une partie (32) de la face supérieure (31) de chaque couche sacrificielle (30),
• l'étape de retrait de chaque couche sacrificielle (30) sélectivement à la première couche de masquage (210) et à la deuxième couche de masquage (220), est effectuée de sorte à former au moins une pluralité de cavités (40),
• l'étape de croissance par épitaxie du matériau III-V à partir de la couche de germination (100) est effectuée de sorte à former une pluralité de premières couches épitaxiées (110), chaque première couche épitaxiée (110) étant située dans une cavité (40),
• la formation d'au moins une troisième ouverture (330) est effectuée de sorte à exposer une partie (112) de la face supérieure (111) de chaque première couche épitaxiée (110),
• l'étape de croissance par épitaxie du matériau III-V à partir de l'au moins une première couche épitaxiée (110) est effectuée de sorte à former une deuxième couche épitaxiée (120) s'étendant depuis chaque première couche épitaxiée (110).

13. Dispositif microélectronique, comprenant un empilement de couches selon une direction verticale (z), ledit empilement comprenant, à partir d'une surface inférieure (500) dudit empilement, une couche de germination (100) cristalline en un matériau III-V, une première couche (110) cristalline à base de ce même matériau et une deuxième couche (120) cristalline à base de ce même matériau, comprenant de plus une première couche de masquage (210) et une deuxième couche de masquage (220), **caractérisé en ce que** la première couche (110) présente une zone (113) qui forme saillie, en projection dans un plan XY normal à la direction verticale (z), par rapport à la deuxième couche (120), la couche de germination (100) et la première couche épitaxiée (110) d'une part, et la première couche épitaxiée (110) et la deuxième couche épitaxiée (120) d'autre part, sont en contact, et dans lequel la première couche (110) s'étend selon la direction verticale (z) sur une épaisseur H110 et la deuxième couche (120) s'étend selon la direction verticale (z) sur une épaisseur H120, avec H120>2*H110 et de préférence H120>3*H110.

14. Dispositif selon la revendication précédente, dans lequel la première couche (110) présente une première zone dopée (1001), de dopage de type N ou de type P, et la deuxième couche (120) présente à sa surface une deuxième zone dopée (1002), de dopage de l'autre type parmi le type N ou le type P.

15. Dispositif selon la revendication précédente, comportant une première électrode (2001) en contact avec la deuxième zone dopée (1002), et une deuxième électrode (2002) en contact avec la première zone dopée (1001) et dans lequel, de préférence la deuxième couche épitaxiée (120) est entourée d'une quatrième couche de masquage (240), et la deuxième électrode (2002) s'étend au travers de la quatrième couche de masquage (240, 230) et depuis une face supérieure (2342) de la quatrième couche de masquage (240, 230) jusqu'à la première zone dopée (1001).
